Europäisches Patentamt

European Patent Office

Office européen des brevets

(11) Publication number: **0 457 344 A2**

## EUROPEAN PATENT APPLICATION

(21) Application number: 91108027.3

(22) Date of filing: **17.05.91**

(51) Int. Cl.⁵: **H01L 21/60**, H01L 23/492, H01S 3/025

(30) Priority: **18.05.90 JP 128361/90**
**31.10.90 JP 294063/90**

(43) Date of publication of application:
**21.11.91 Bulletin 91/47**

(84) Designated Contracting States:
**DE FR GB**

(71) Applicant: **Kabushiki Kaisha Toshiba**
**72, Horikawa-cho Saiwai-ku**
**Kawasaki-shi(JP)**

Applicant: **TOSHIBA ELECTRONIC**
**ENGINEERING CORPORATION**
**72 Horikawa-cho, Saiwai-ku**
**Kawasaki-shi(JP)**

(72) Inventor: **Tamura, Hideo, c/o Intell. Property**
**Div.**
**Kabushiki Kaisha Toshiba, 1-1 Shibaura**
**1-chome**
**Minato-ku, Tokyo 105(JP)**
Inventor: **The other inventors have agreed to**
**waive their entitlement to designation**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor light-emitting device.

(57) A 2-beam semiconductor laser device includes a heat sink (24), an electrically insulating submount (23) arranged thereon, and a light-emitting chip (20) mounted thereon in a junction-down type. The first surface of the chip (20) constituted by a p-type semiconductor layer is fixed on the submount (23). An isolation groove (22) is formed from the first surface of the chip (20) to the inside of the chip (20) to divide the first surface into two portions. An Au-Zn layer (26) serving as an ohmic contact electrode layer and an Au-Ge layer (25) serving as a soldering layer are arranged on each portion of the first surface of the chip (20). An Mo layer (28) is arranged between the Au-Zn layer (26) and the Au-Ge layer (25). The Mo layer (28) has a melting point higher than that of the soldering layer (25) to prevent mixing of the Au-Zn layer (26) with the Au-Ge layer (25). An electrode wiring metal layer (36) is arranged on the submount (23) and bonded to the Au-Ge layer (25) serving as the soldering layer.

FIG. 3

The present invention relates to a semiconductor light-emitting device and, more particularly, to a multi-beam semiconductor laser device.

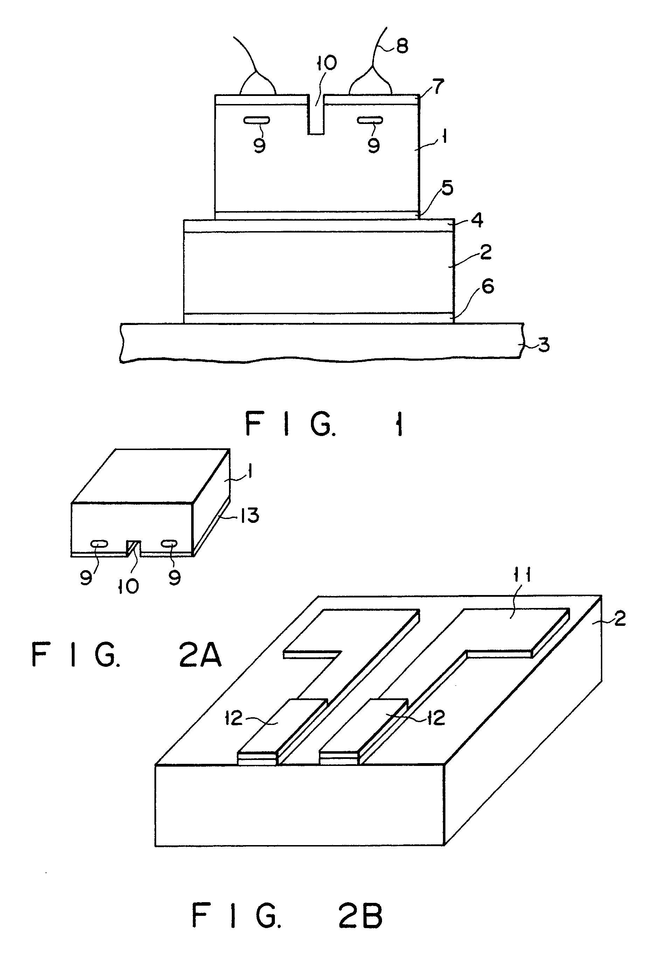

A conventional multi-beam semiconductor laser device which is a kind of semiconductor light-emitting device will be described below with reference to Fig. 1.

A multi-beam semiconductor laser device is constituted by mounting a chip 1 on a heat sink 3 through an electrically insulating submount 2 and a soldering layer 6. In such a multi-layered structure, a soldering layer, e.g., an Au-Sn alloy layer 4 for covering the entire surface of the submount 2 is in contact with and integrally fixed on an electrode 5 formed on the surface of the chip 1. As the soldering layer 4, a chip-like layer called a preform, or a thin film deposited by a vacuum deposition method or a sputtering method may be used.

In a multi-beam semiconductor laser device, in order to independently emit a plurality of beams, a so-called junction-up method is generally employed. For this reason, as shown in Fig. 1, a current is supplied to the multi-beam semiconductor laser device through a metal thin line 8 fixed on an electrode 7 of the top surface of a multi-beam semiconductor laser device chip 1.

Light-emitting portions 9 formed on the multi-beam semiconductor laser device chip 1 are preferably formed as follows. That is, a crystal is deposited on a substrate having a thickness of 70 to 100 μm by an LPE (Liquid Phase Epitaxy) method, and the thickness of a crystal growing layer from the light-emitting portions 9 to the top surface of the multi-beam semiconductor laser device chip 1 is preferably decreased to easily separate beams from each other. Therefore, although a distance between the light-emitting portion 9 and the top surface of the chip 1 in Fig. 1 is as small as 5 μm to 10 μm, the distance between the light-emitting portion 9 and the electrically insulating submount 2 is as large as 70 μm to 100 μm.

In contrast to this, a so-called junction-down method is known as a method of improving heat radiation. In this example, as shown in Figs. 2A and 2B, light-emitting portions 9 of a multi-beam semiconductor laser device chip 1 are arranged to be close to an electrode submount 2.

As shown in Fig. 2A, an isolation groove 10 for independently operating the light-emitting portions 9 is formed in the chip 1, as in the example in Fig. 1. A layer 13 made of Ti, Pt, or Au and serving as an ohmic contact layer is formed on the lower surface of the chip 1.

As shown in Fig. 2B, Au electrodes 11 having a symmetric shape are formed on the electrically insulating submount 2 by patterning. An Sn-Pb soldering layer 12 is stacked on each of the electrodes 11 to prepare for mounting of the chip 1. In order to form the soldering layer 12 on the electrically insulating submount 2, the soldering layer 12 is not mixed with Au serving as the electrode metal and must be partially removed.

As described above, when the multi-beam semiconductor laser device chip 1 is mounted on the electrically insulating submount 2 by a junction-up method, a radiation effect of heat generated from each light-emitting point is reduced due to the long distance between the chip 1 and the light-emitting point. Therefore, the temperature of the multi-beam semiconductor laser device chip 1 is increased to degrade its reliability. In addition, thermal interference between the light-emitting points 9 is increased to prevent independent driving of the light-emitting portions.

In the junction-down method, the Au of the electrode metal is not mixed with the Sn-Pb alloy of the soldering layer, and the soldering layer must be partially removed. However, this is very difficult to be realized at a present technique level. In addition, although the soldering layer may be formed by a vacuum deposition method using a metal mask, the soldering layer is difficult to be precisely patterned in this method. In this method, when the interval between the light-emitting points of the multi-beam semiconductor laser device is 100 μm or less, the light-emitting points can hardly be electrically isolated from each other.

The present invention has been made in consideration of the above problem, and has as its object to provide a semiconductor light-emitting device which has satisfactory heat radiation and small thermal interference between light-emitting points and therefore can be easily operated with any interval between the light-emitting points.

According to the first aspect of the present invention, a semiconductor light-emitting device comprises a heat sink, an electrically insulating submount, a first surface of the submount being fixed on the heat sink, a semiconductor light-emitting device chip, a first surface of the chip being fixed on a second surface of the submount, an isolation groove formed from the first surface of the chip to an inside of the chip to divide the first surface of the chip into at least two portions, an ohmic contact electrode layer formed on each portion of the first surface of the chip, a soldering layer formed on the ohmic contact electrode layer, refractory metal layer means arranged between the ohmic contact electrode layer and the soldering layer, the refractory metal layer means having a melting point higher than that of the soldering layer, and electrode wiring metal layer means formed on the second surface of the submount corresponding to the soldering layer, the electrode wiring metal layer means being bonded to the soldering layer.

In a preferable aspect, the first surface of the chip is constituted by a p-type semiconductor layer. The refractory metal layer means is constituted by only a molybdenum layer or has a titanium layer between the molybdenum layer and the ohmic contact electrode. The ohmic contact electrode layer is constituted by a gold-zinc alloy layer, and the soldering layer is constituted by a gold-germanium alloy layer.

According to the first aspect of the present invention, when a temperature is increased to the melting point or more of the soldering layer in order to fix the chip on the submount, since the molybdenum layer prevents mixing of the ohmic contact electrode metal layer with the soldering layer, an ohmic contact electrode resistance is not increased. In addition, any defective connection between the soldering layer and the electrode wiring metal layer of the submount does not occur. Therefore, a highly reliable semiconductor light-emitting device can be obtained.

The operation and effect of the titanium layer arranged between the ohmic contact electrode metal layer and the molybdenum layer will be described below. When the ohmic contact electrode metal layer and the molybdenum layer are to be formed on a chip, two exclusive isotropic etching solutions for these layers are required. However, when interface portions of the ohmic contact electrode metal layer and the molybdenum layer are mixed with each other while being deposited, the layers cannot be processed even by the exclusive isotropic etching solutions. For this reason, when a titanium layer having a melting point lower than that of the molybdenum layer is arranged between the layers, the interface portions of the ohmic contact electrode metal layer and the molybdenum layer are not mixed with each other, and the exclusive isotropic etching solutions can be used. In addition, the titanium layer having a melting point lower than that of the molybdenum layer can minimize mixing of the ohmic contact electrode metal layer and the molybdenum layer.

A reason for selecting molybdenum or titanium as a refractory metal is that these metals have a thermal expansion coefficient similar to that of GaAs used as a semiconductor substrate and these metals are advantageously patterned easier than platinum or tungsten.

According to the second aspect of the present invention, a semiconductor light-emitting device comprises a heat sink, an electrically insulating submount, a first surface of the submount being fixed on the heat sink, a semiconductor light-emitting device chip, a first surface of the chip being constituted by a n-type semiconductor layer and fixed on a second surface of the submount, an isolation groove formed from the first surface of the chip to an inside of the chip to divide the first surface of the chip into at least two portions, a soldering layer arranged on each portion of the first surface of the chip and constituted by a gold-germanium alloy layer, the soldering layer serving as an ohmic contact electrode, and electrode wiring metal layer means formed on the second surface of the submount corresponding to the soldering layer, the electrode wiring metal layer means being bonded to the soldering layer.

In the preferable aspect, the electrode wiring metal layer means has a gold layer facing the soldering layer and a nickel layer facing the submount.

In a semiconductor light-emitting device according to the second aspect, since a method of covering the soldering layer on the first surface of the chip to fix the submount to the chip is employed, only patterning of an electrode made of Au, for example, is performed on a surface of the submount to be processed. On the other hand, as the soldering layer for covering the chip surface is removed from only a portion corresponding to the isolation groove, selective etching is not required to be performed. As described above, a structure for a junction-down method can be easily obtained. In addition, even when the interval between light-emitting points is as short as 100 $\mu$m or less, the soldering layer can be formed by a normal photolithographic technique.

The present invention is preferably used especially for a multi-beam semiconductor laser device.

This invention can be more fully understood from the following detailed description when taken in conjunction with the accompanying drawings, in which:

Fig. 1 is a side view showing a junction-up type 2-beam semiconductor laser device;

Figs. 2A and 2B are perspective views showing a conventional junction-down type 2-beam semiconductor laser device;

Fig. 3 is a side view showing the 2-beam semiconductor laser device according to the first embodiment of the present invention;

Fig. 4 is a side view showing the 2-beam semiconductor laser device according to the second embodiment of the present invention;

Fig. 5 is a perspective view showing a laser chip of the devices according to the first and second embodiments of the present invention;

Fig. 6 is a perspective view showing a 2-beam semiconductor laser device mounted on an electronic machine;

Fig. 7 is a plan view showing a 2-beam semiconductor laser device;

Fig. 8 is a side view showing a 2-beam semiconductor laser device according to the third embodiment of the present invention; and

Fig. 9 is a perspective view showing a laser chip of the device according to the third embodiment of the present invention.

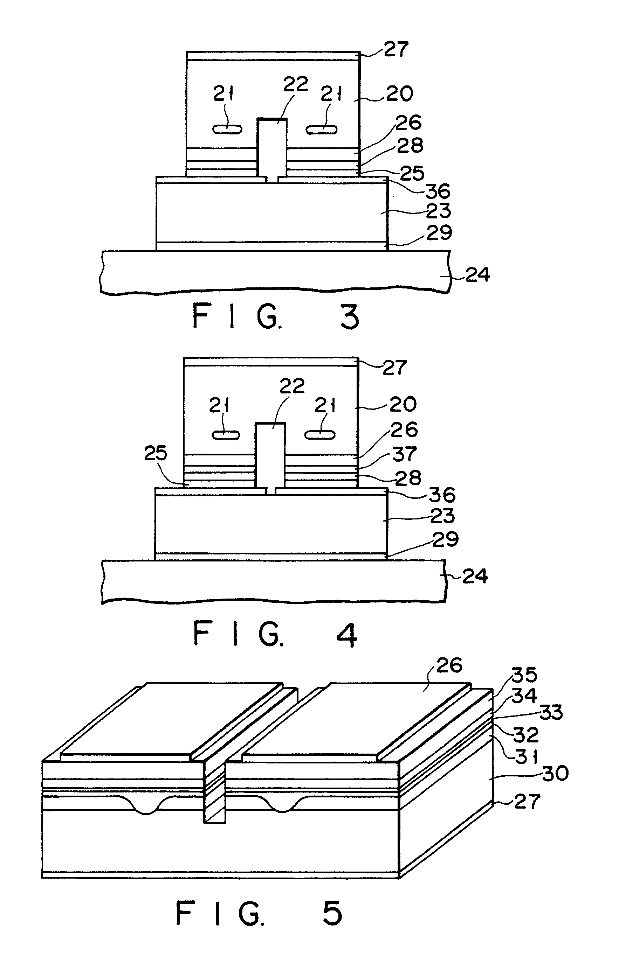

In a 2-beam semiconductor laser device of the first embodiment shown in Fig. 3, an isolation groove 22 is formed between flat light-emitting portions 21 and 21 in a chip 20 by, e.g., a reactive dry-etching method to electrically isolate the portions 21 and 21. The chip 20 is fixed on a heat sink 24 through an electrically insulating submount 23. The submount 23 is made of silicon and has a high-resistance insulating property.

In order to mount the 2-beam semiconductor laser chip on the submount 23 by a junction-down method, an Au-Ge soldering layer 25 containing about 12% of Ge is used. A layer deposited by a deposition method and having a thickness of about 2 $\mu$m is preferably used as the soldering layer 25. An Au-Zn alloy layer 26 having a thickness of about 0.5 $\mu$m and serving as an ohmic contact electrode of the 2-beam semiconductor laser chip 20 is formed adjacent to the soldering layer 25. Portions of the semiconductor layer 25 and the alloy layer 26 corresponding to the isolation groove 22 are removed by a patterning process using a photolithographic technique.

In the first embodiment, the chip 20 is formed using an n-type semiconductor substrate made of, e.g., GaAs. A common electrode 27 having a thickness of about 1 $\mu$m and made of an Au-Ge alloy is formed on the upper end of the chip 20 to form an ohmic contact electrode of the chip 20. The electrode 27 functions as a common electrode for the two beams. A soldering layer 29 made of an Au-Sn alloy and having a thickness of about 3 $\mu$m is formed on the lower surface of the submount 23 to fix the submount 23 on the heat sink 24.

In addition, a first refractory metal layer 28 which is the most important element of the present invention will be described below. That is, in order to prevent mixing of an Au-Zn alloy layer serving as an ohmic contact electrode with the Au-Ge soldering layer 25, an Mo layer 28 having a thickness of about 0.2 $\mu$m is formed by a deposition method or the like.

The Au-Ge soldering layer 25, the Au-Zn alloy layer 26, and the Mo layer, i.e., the first refractory metal layer 28 are deposited on the surface of the chip 20 by a general resistive heat deposition method or an E (electron) gun deposition method. Thereafter, the soldering layer 25 and the alloy layer 26 are patterned using a resist as a mask by an Au-etching solution containing cyanogen. When the first refractory metal layer 28 and the Au-Zn alloy layer 26 are mixed to each other during this deposition, etching is not easily performed. An increase in temperature must be suppressed in a deposition step.

The structure of the 2-beam semiconductor laser chip 20 will be described below with reference to the perspective view of Fig. 5. A current block layer 31 made of p-type GaAs is formed on one surface of an n-type GaAs substrate, and the following parts are stacked by an LPE method in an order to be named. That is, the chip 20 is constituted by an n-type GaAℓAs cladding layer 32, a p-type GaAℓAs active layer 33, a p-type GaAℓAs cladding layer 34, a p-type GaAs ohmic layer 35, and an electrode 26.

A patterned electrode wiring metal layer 36 made of Au is formed on the surface of the submount 23 fixed on the chip 20. The metal layer 36 is bonded to the soldering layer 25 of the chip 1.

A 2-beam semiconductor laser device according to the second embodiment in Fig. 4 has the same structure as the device shown in Fig. 3 except for the point to be described below. Therefore, the same reference numerals as in Fig. 3 denote the same parts in Fig. 4, and a detailed description thereof will be omitted.

In the second embodiment shown in Fig. 4, a Ti layer 37 having a thickness of about 0.1 $\mu$m, i.e., a second refractory metal layer is added to a first refractory metal layer 28. Ti is deposited by the E gun deposition method and patterned by a hydrofluoric acid isotropic-etching solution using a resist as a mask, thereby forming the Ti layer 37. Since Ti has a melting point lower than that of Mo, an increase in temperature during deposition is extremely suppressed. As a result, the Au-Zn alloy layer 26 and the Ti layer 37 are not mixed with each other, exclusive isotropic etching solutions for these layers can be used, and patterning precision can be improved.

Although a patterning precision of ±2 to 3 $\mu$m with respect to a pattern of 5 $\mu$m is obtained by a conventional technique, the patterning precision can be improved to ±1 $\mu$m or less. Therefore, the submount 23 cannot be detached from the chip 20, and an increase in electric resistance between them which obstructs the electric contact therebetween can be prevented, thereby improving the reliability of the device.

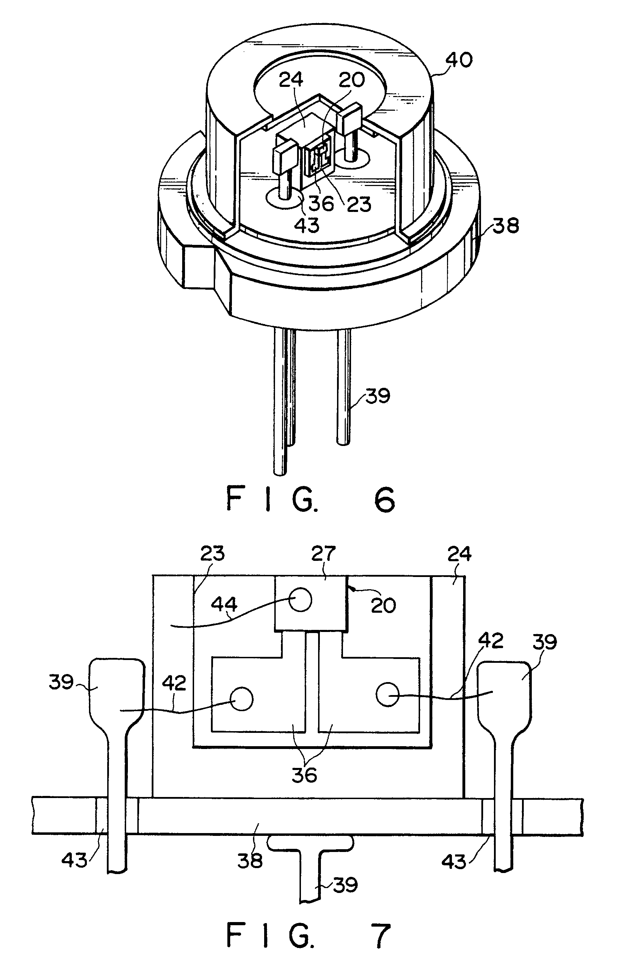

The 2-beam semiconductor laser chip 20 mounted on the heat sink 24 through the electrically insulating submount 23 is mounted on a system to be connected to other electronic machines as is apparent in Fig. 6. For this reason, a plurality of leads 39 are hermetically sealed to a supporting member 38 made of a metal using a glass layer 43 (Fig. 7). The chip 20 mounted on the heat sink 24 through the submount 23 is mounted on the supporting member 38. A shielding member 40 having an opening at its center covers the resultant structure, ant it serves as an envelope.

Fig. 7 is a plan view showing the 2-beam semiconductor laser device in Figs 3 and 4. A connecting state of the electrode 36 formed on the submount 23 and the leads 39 by an Au thin lines 42 and a connecting state of the chip 20 and the heat sink 24 using an Au thin line 44 are shown in Fig. 7. A hermetic-sealing glass layer 43 is arranged between the leads 39 formed through the support member 38.

The Au thin lines 42 are thermally or ultrasonically bonded to the electrodes 36 patterned on the exposed surface of the submount 23 by a bonding method. The above connection allows currents to be supplied to the light-emitting portions 21. In addition, the 2-beam semiconductor laser chip 20 and the heat sink 24 are connected to each other by an Au thin line 44, and they serve as a common electrode for the light-emitting portions.

With the above arrangement, according to the present invention, the minimum interval between the light-emitting portions of the two beams can be 30 μm. In this case, when a current for extracting a light output of 10 mW from one light-emitting portion while an light output of 10 mW from the other light-emitting portion was supplied to the semiconductor device, a thermal crosstalk amount representing a rate of decreasing the light output emitted first due to the heat was 5% or less (the interval between the light-emitting portions is 30 μm). This value is half or less of that of a conventional junction-up type semiconductor device.

Fig. 8 is a semiconductor light-emitting device according to the third embodiment of the present invention. Between flat light-emitting portions 121 and 121 formed on a 2-beam semiconductor laser chip 120 shown in Fig. 8, an isolation groove 122 for electrically isolating the light-emitting portions 121 and 121 is formed by the well-known anisotropic etching method, e.g., a reactive dry-etching method. The semiconductor chip 120 is mounted on a heat sink 124 through an electrically insulating submount 123. This mounting is performed by a so-called junction-down method. The electrically insulating submount 123 is made of, e.g., silicon and has a high resistance. The 2-beam semiconductor laser chip 120 is mounted on the submount 123 by an Au-Ge soldering layer 125 containing about 12% of Ge, and a layer deposited by a vacuum deposition method or a sputtering method to have a thickness of about 1.5 μm is preferably used as the soldering layer 125. The soldering layer 125 is patterned by a lithographic technique to remove a portion corresponding to the isolation groove.

The 2-beam semiconductor laser chip 120 is constituted by a p-type semiconductor substrate made of, e.g., GaAs, its surface fixed to the electrically insulating submount 123 is converted into an n-type semiconductor. Therefore, the Au-Ge soldering layer 125 can also serve as an ohmic electrode layer.

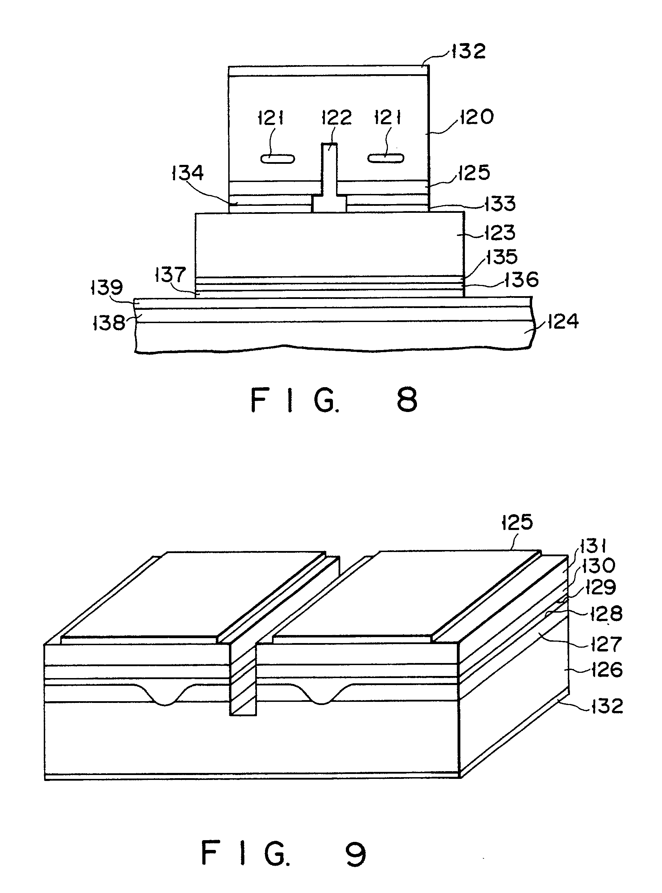

The structure of the 2-beam semiconductor laser chip 120 will be described below with reference to the perspective view of Fig. 9. A current blocking layer 127 made of n-type GaAs is formed on one surface of a p-type GaAs substrate 126, and the following parts are stacked on the p-type GaAs substrate 126 in an order to be named. That is, the 2-beam semiconductor laser chip 120 has a stacked structure constituted by a p-type GaAℓAs cladding layer 128, a p-type GaAℓAs active layer 129, an n-type GaAℓAs cladding layer 130, an n-type GaAs ohmic layer 131, and an n-type electrode 125.

As shown in Fig. 8, an Ni layer 133 having a thickness of about 0.5 μm and an Au layer 134 having a thickness of about 1 μm are sequentially formed on the surface of the electrically insulating submount 123 to be processed. As a result, an alloy layer is integrally formed between the electrically insulating submount 123 and the soldering layer 125. Since the soldering layer 125 is patterned along the opening surface of the isolation groove 122, the Ni layer 133 and the Au layer 134 are patterned by the well-known lithographic technique to·form an electrode.

A plurality of metal layers are stacked on the surface of the electrically insulating submount 123 fixed to the heat sink 124. That is, a Ti layer 135 having a thickness of about 0.2 μm, a Pt layer 136 having a thickness of about 0.2 μm, and an Au-Ge layer 137 having a thickness of about 1.5 μm and serving as a soldering layer are sequentially deposited from the lower surface of the submount 123 by a vacuum deposition method or a sputtering method. In addition, in order to prevent oxidation of the surface of the heat sink 124, an Ni layer 138 having a thickness of about 3 μm and an Au layer 139 having a thickness of about 2.0 μm are sequentially formed on the upper surface of the heat sink 124 by a plating method.

The semiconductor light-emitting device of the third embodiment can be used in a mode shown in Fig. 6, as well as the devices of the first and second embodiments.

The above embodiments are described by the semiconductor laser devices. However, the present invention can be applied to any other light-emitting devices and to a device having three or more light-emitting portions. Note that the present invention can be applied to any light-emitting devices in addition to the semiconductor laser device.

**Claims**

1. A semiconductor light-emitting device characterized by comprising:

a heat sink (24);

an electrically insulating submount (23), a first surface of said submount (23) being fixed on said heat sink (24);

a semiconductor light-emitting device chip (20), a first surface of said chip (20) being fixed on a second surface of said submount (23);

an isolation groove (22) formed from the first surface of said chip (20) to an inside of the said chip (20) to divide the first surface of said chip (20) into at least two portions;

an ohmic contact electrode layer (26) formed on each portion of the first surface of said chip (20);

a soldering layer (25) formed on said ohmic contact electrode layer (26);

refractory metal layer means (28) arranged between said ohmic contact electrode layer (26) and said soldering layer (25), said refractory metal layer means (28) having a melting point higher than that of said soldering layer (25); and

electrode wiring metal layer means (36) formed on the second surface of said submount (23) corresponding to each of said soldering layers (25), said electrode wiring metal layer means (36) being bonded to said soldering layer.

2. A device according to claim 1, characterized in that the first surface of said chip (20) is constituted by a p-type semiconductor layer.

3. A device according to claim 1, characterized in that said refractory metal layer means (28) is constituted by a plurality of refractory metal layers.

4. A device according to claim 1, characterized in that said refractory metal layer means is constituted by a molybdenum layer (28).

5. A device according to claim 4, characterized in that said refractory metal layer means has a titanium layer (37) between said molybdenum layer (28) and said ohmic contact electrode layer (26).

6. A device according to claim 2, characterized in that said ohmic contact electrode layer is constituted by a gold-zinc alloy layer (26).

7. A device according to claim 6, characterized in that said soldering layer is constituted by a gold-germanium alloy layer (25).

8. A device according to claim 1, characterized in that said semiconductor light-emitting device is a multi-beam semiconductor laser device.

9. A semiconductor light-emitting device characterized by comprising:

a heat sink (124);

an electrically insulating submount (123), a first surface of said submount (123) being fixed on said heat sink (124);

a semiconductor light-emitting device chip (120), a first surface of said chip (120) being fixed on a second surface of said submount (123);

an isolation groove (122) formed from the first surface of said chip (120) to an inside of the said chip (120) to divide the first surface of the chip (120) into at least two portions;

a soldering layer (125) arranged on each portion of the first surface of said chip (120) and constituted by a gold-germanium alloy layer, said soldering layer (125) serving as an ohmic contact electrode; and

electrode wiring metal layer means (133, 134) formed on the second surface of said submount (123) corresponding to said soldering layer (125), said electrode wiring metal layer means (133, 134) being bonded to said soldering layer (125).

10. A device according to claim 9, characterized in that said electrode wiring metal layer means has a gold layer (134) facing said soldering layer (125).

11. A device according to claim 10, characterized in that said electrode wiring metal layer means has a nickel layer (133) facing said submount (123).

12. A device according to claim 9, characterized in that said semiconductor light-emitting device is a multi-beam semiconductor laser device.

F I G. 1

F I G. 2A

F I G. 2B

F I G. 3

F I G. 4

F I G. 5

F I G. 6

F I G. 7

FIG. 8

FIG. 9